# FASCICULE DE BREVET EUROPEEN

(11) **EP 3 188 238 B1**
(45) Date de publication et mention de la délivrance du brevet: **25.04.2018**
(21) Numéro de dépôt: 16203843.4
(22) Date de dépôt: 13.12.2016
(51) Int. Cl.: H01L 27/146, G01S 7/486

(54) **PIXEL DE DÉTECTION DE TEMPS DE VOL**
FLUGZEIT-ERFASSUNGSPIXEL
PIXEL FOR DETECTING FLIGHT TIME

(30) Priorité: 30.12.2015 FR 1563457
(43) Date de publication de la demande: 05.07.2017
(73) Titulaire: STMicroelectronics (Crolles 2) SAS, 38920 Crolles (FR); COMMISSARIAT À L'ÉNERGIE ATOMIQUE ET AUX ÉNERGIES ALTERNATIVES, 75015 Paris (FR)
(72) Inventeur: ROY, François, 38180 SEYSSINS (FR); GUILLON, Marie, 38120 FONTANIL-CORNILLON (FR); CAZAUX, Yvon, 38100 GRENOBLE (FR); RODRIGUES, Boris, 38000 GRENOBLE (FR); ROCHAS, Alexis, 38500 COUBLEVIE (FR)
(74) Mandataire: Thibon, Laurent

(56) Documents cités:
- EP-A1- 2 881 991
- US-A1- 2011 019 049
- US-B1- 9 117 712

## Description

### Domaine

La présente demande concerne un capteur de distance fonctionnant sur le principe de la mesure de temps de vol, ou capteur TOF ("Time Of Flight" - temps de vol).

### Exposé de l'art antérieur

Dans un capteur TOF, une source lumineuse émet de la lumière en direction d'une scène. Un pixel de détection de temps de vol, ou pixel TOF, du capteur reçoit la lumière renvoyée par un point de la scène conjugué avec ce pixel. La mesure du temps de vol, c'est-à-dire du temps mis par la lumière pour effectuer le trajet de la source lumineuse vers le point de la scène auquel est conjugué le pixel, et de ce point jusqu'au pixel, permet de calculer la distance séparant le pixel de ce point. Le document US9117712 divulgue un pixel de détection de temps de vol. Dans le cas où l'on cherche à obtenir une image en relief d'une scène, le capteur TOF comprend une matrice de pixels TOF pour mesurer la distance séparant chaque pixel du point de la scène auquel ce pixel est conjugué. Cela permet d'obtenir une cartographie des distances séparant le capteur des différents points de la scène auxquels les pixels sont conjugués, et une image en relief de la scène peut alors être reconstruite à partir de cette cartographie des distances. Toutefois, les pixels TOF existants ont de relativement grandes dimensions. Par exemple, un pixel TOF comprenant une photodiode de type SPAD ("Single Photon Avalanche Diode" - Diode à avalanche à photon unique) peut avoir une surface de l'ordre de 30 µm*30 µm.

Il serait donc souhaitable de disposer d'un pixel TOF palliant au moins certains des inconvénients des pixels TOF existants, notamment d'un pixel TOF ayant une surface inférieure à 10 µm*10 µm, de préférence inférieure à 5 µm*5 µm.

### Résumé

Ainsi, un mode de réalisation prévoit un pixel de détection de temps de vol comprenant une zone photosensible comportant une première couche dopée d'un premier type de conductivité ; une zone de collection de charges s'étendant dans la première couche et étant plus fortement dopée du premier type que la première couche ; au moins deux zones de stockage de charges s'étendant à partir de la zone de collection et comprenant chacune un premier caisson plus fortement dopé du premier type que la zone de collection et séparé de ladite zone de collection par une première portion de la première couche revêtue d'une première grille, chaque zone de stockage de charges étant délimitée latéralement par deux électrodes conductrices isolées, parallèles et en vis-à-vis l'une de l'autre ; et une deuxième couche fortement dopée du deuxième type de conductivité revêtant le pixel à l'exception de chaque portion de la première couche revêtue d'une grille.

Selon un mode de réalisation, la première couche repose sur un substrat semiconducteur dopé du deuxième type de conductivité.

Selon un mode de réalisation, la zone de collection se prolonge par des doigts dopés du premier type, revêtus de la deuxième couche, et s'étendant dans la zone photosensible, les doigts étant plus fortement dopés que la première couche et plus faiblement dopés ou de même niveau de dopage que la zone de collection.

Selon un mode de réalisation, la zone de collection est disposée dans une partie centrale de la zone photosensible.

Selon un mode de réalisation, le pixel comprend en outre, sous chaque première grille, une zone intermédiaire dopée du premier type intercalée entre la première portion correspondante et le premier caisson correspondant, la zone intermédiaire étant plus fortement dopée que la première portion correspondante et plus faiblement dopée que le premier caisson correspondant.

Selon un mode de réalisation, le pixel comprend en outre une région plus fortement dopée du deuxième type que la zone de collection, adaptée à être couplée à un potentiel de référence, et séparée de la zone de collection par une deuxième portion de la première couche revêtue d'une deuxième grille.

Selon un mode de réalisation, le pixel comprend en outre, pour chaque zone de stockage, une zone de lecture plus fortement dopée du deuxième type que le premier caisson, la zone de stockage s'étendant jusqu'à la zone de lecture et étant séparée de la zone de lecture par une troisième portion de la première couche revêtue d'une troisième grille.

Selon un mode de réalisation, le pixel comprend en outre, pour chaque zone de stockage, au moins une zone mémoire s'étendant à partir de la zone de stockage et comprenant un deuxième caisson plus fortement dopé du deuxième type que le premier caisson, revêtu de la deuxième couche, et séparé du premier caisson par une troisième portion de la première couche revêtue d'une troisième grille, la zone mémoire étant délimitée latéralement par deux électrodes conductrices isolées, parallèles et en vis-à-vis l'une de l'autre.

Selon un mode de réalisation, le pixel comprend deux zones de stockage dont chacune est associée à deux zones mémoire.

Selon un mode de réalisation, le pixel comprend en outre, pour chaque zone mémoire, une zone de lecture plus fortement dopée du deuxième type que le deuxième caisson, la zone mémoire s'étendant jusqu'à la zone de lecture et étant séparée de la zone de lecture par une quatrième portion de la première couche revêtue d'une quatrième grille.

Selon un mode de réalisation, chaque zone de lecture est électriquement connectée à une même borne d'un circuit de lecture.

Un mode de réalisation prévoit un capteur d'image comprenant une matrice de pixels tels que ci-dessus associée à une source d'émission de lumière modulée, et des moyens adaptés à synchroniser ladite source et des potentiels de commande appliqués aux grilles de transistors du pixel.

Selon un mode de réalisation, chaque première grille est adaptée à recevoir ou non un premier potentiel pour autoriser ou interdire un transfert de charges de la zone de collection vers la zone de stockage correspondante.

Selon un mode de réalisation, chaque troisième grille est adaptée à recevoir ou non un deuxième potentiel pour autoriser ou interdire un transfert de charges de la zone de stockage correspondante vers la zone de lecture correspondante.

Selon un mode de réalisation, chaque troisième grille est adaptée à recevoir ou non un deuxième potentiel pour autoriser ou interdire un transfert de charges de la zone de stockage correspondante vers la zone mémoire correspondante, et, en outre, chaque quatrième grille est adaptée à recevoir ou non un troisième potentiel pour autoriser ou interdire un transfert de charges de la zone mémoire correspondante vers la zone de lecture correspondante.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue de dessus représentant schématiquement un exemple d'un capteur TOF ;
la figure 2 représente un exemple d'un circuit de pixel TOF ;
la figure 3 est un chronogramme illustrant un mode de commande du pixel TOF de la figure 2 ;
les figures 4A à 4C représentent schématiquement un mode de réalisation d'un pixel TOF du type de celui de la figure 2 ;
la figure 5 est une vue en coupe schématique d'une variante de réalisation du pixel TOF des figures 4A à 4C ;
les figures 6A et 6B représentent schématiquement une autre variante de réalisation du pixel TOF des figures 4A à 4C ; et
les figures 7A à 7D représentent schématiquement un autre mode de réalisation d'un pixel TOF.

### Description détaillée

De mêmes éléments ont été désignés par de mêmes références dans les différentes figures et, de plus, les diverses figures ne sont pas tracées à l'échelle. Par souci de clarté, seuls les éléments qui sont utiles à la compréhension des modes de réalisation décrits ont été représentés et sont détaillés.

Dans la description qui suit, les termes "haut", "bas", "gauche", "droite", "sous", "sur", "vertical" et "supérieur" se réfèrent aux éléments concernés dans les figures correspondantes. Sauf précision contraire, les expressions "sensiblement", "environ" et "de l'ordre de" signifient à 10 % près, de préférence à 5 % près.

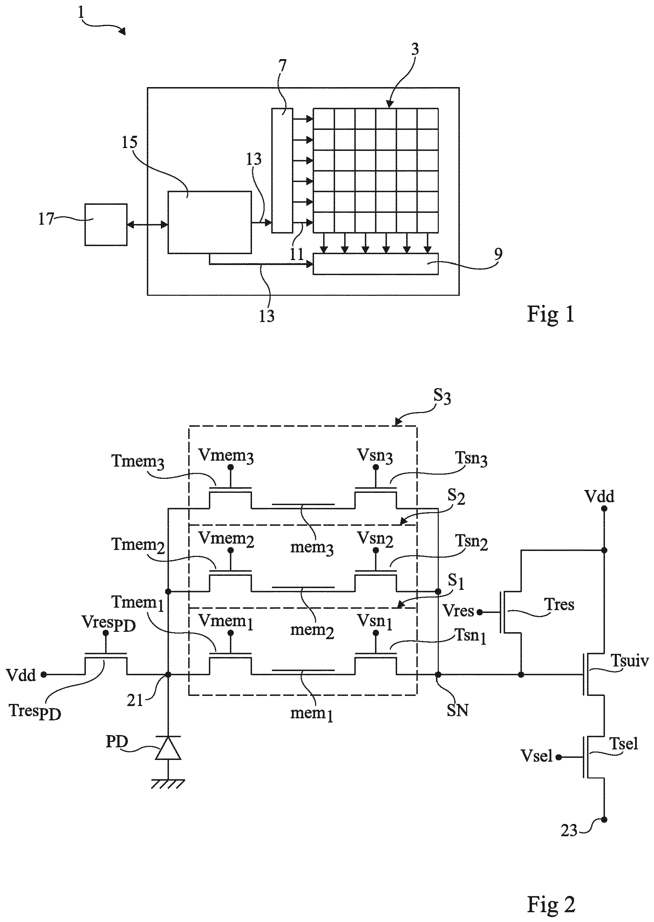

La figure 1 est une vue de dessus schématique d'un exemple de capteur TOF. Le capteur 1 comprend une matrice 3 de pixels TOF, par exemple une matrice de 1000 lignes par 1000 colonnes. La matrice 3 est associée à un décodeur de ligne 7 et à un décodeur de colonne 9. Le décodeur de ligne 7 fournit des signaux 11 permettant de sélectionner l'une ou l'autre des lignes de la matrice. Le décodeur de colonne 9 permet de lire les informations des pixels d'une ligne sélectionnée. Le décodeur de ligne 7 et le décodeur de colonne 9 sont commandés par des signaux 13 fournis par des moyens de commande et de traitement 15. Les moyens de commande et de traitement 15 comprennent, par exemple, un processeur associé à une ou plusieurs mémoires. Le capteur 1 est associé à une source lumineuse 17 pour illuminer une scène dont on souhaite obtenir l'image en relief. Cette source lumineuse 17 est par exemple un laser dont la longueur d'onde peut être comprise entre 500 et 1000 nm. La source lumineuse 17 est connectée aux moyens de commande et de traitement 15 pour synchroniser les signaux de commande appliqués aux pixels TOF de la matrice 3 et la source lumineuse 17.

Dans la suite de la description, on s'intéresse au cas d'un capteur 1 dans lequel la source lumineuse 17 émet un signal sinusoïdal LE dont la fréquence peut être comprise entre 20 et 100 MHz, par exemple 25 MHz. Pour chaque pixel, on détermine le déphasage ϕ entre le signal lumineux LE émis et le signal lumineux L_{R} reçu par ce pixel. La distance séparant le pixel de son point conjugué est ensuite déterminée à partir de ce déphasage ϕ.

La figure 2 représente un exemple d'un circuit d'un pixel TOF.

Le pixel TOF comprend un élément photosensible PD dont une borne est connectée à un noeud 21 et dont l'autre borne est connectée à un potentiel bas de référence, par exemple la masse. Le noeud 21 est couplé à un noeud de lecture SN par l'intermédiaire de trois ensembles identiques S1, S2 et S3 connectés en parallèle entre les noeuds 21 et SN. Chaque ensemble Sᵢ, avec i égale 1, 2 ou 3 dans cet exemple, comprend un transistor MOS à canal N de transfert, Tmemᵢ, une zone de stockage de charges memᵢ et un transistor MOS à canal N de lecture, Tsnᵢ. La source du transistor Tmemᵢ est connectée au noeud 21, et le drain du transistor Tmemᵢ est connecté à une borne de la zone de stockage memᵢ. Le transistor Tmemᵢ est commandé par un signal Vmemᵢ appliqué sur sa grille. La source du transistor Tsnᵢ est connectée à l'autre borne de la zone de stockage memᵢ, et le drain du transistor Tsnᵢ est connecté au noeud de lecture SN. Le transistor Tsnᵢ est commandé par un signal Vsnᵢ appliqué sur sa grille. Des exemples de zones de stockage memᵢ seront donnés ci-après.

Le pixel TOF est associé à un dispositif de lecture qui peut être commun à plusieurs pixels, par exemple quatre pixels. Le dispositif de lecture comporte un transistor MOS à canal N de précharge, Tres, un transistor MOS à canal N monté en source suiveuse, Tsuiv, et un transistor MOS à canal N de sélection, Tsel connectés comme représenté. Le noeud de lecture SN est couplé à un potentiel haut de référence, par exemple le potentiel d'alimentation Vdd, par le transistor Tres, ce dernier étant commandé par un signal Vres appliqué sur sa grille. Le noeud de lecture SN est également couplé à la grille du transistor Tsuiv dont le drain est couplé au potentiel haut de référence, et dont la source est couplée à une ligne de sortie 23 du circuit du pixel par l'intermédiaire du transistor Tsel, le transistor Tsel étant commandé par un signal Vsel appliqué sur sa grille.

Dans cet exemple, le pixel TOF comprend, en outre, un transistor MOS à canal N, Tres_{PD}, de remise à zéro de l'élément photosensible PD. La source du transistor Tres_{PD} est connectée au noeud 21 et le drain du transistor Tres_{PD} est connecté au potentiel haut Vdd. Le transistor Tres_{PD} est commandé par un signal Vres_{PD} appliqué sur sa grille.

Pour déterminer le déphasage ϕ entre le signal lumineux LE émis et le signal lumineux L_{R} reçu par le pixel, le signal L_{R} est échantillonné en transférant, successivement et à intervalles réguliers, des charges photogénérées dans l'élément photosensible vers les zones de stockage mem₁, puis mem₂ et finalement mem₃. La durée totale pour réaliser l'ensemble de ces trois transferts successifs est égale à une période des signaux LE et L_{R}. En outre, l'ensemble de ces trois transferts successifs est répété un grand nombre de fois, par exemple au moins 100000 fois. Les charges accumulées dans les zones de stockage sont ensuite lues en transférant, vers le noeud SN, les charges de la zone mem₁, puis de la zone mem₂ et finalement de la zone mem₃.

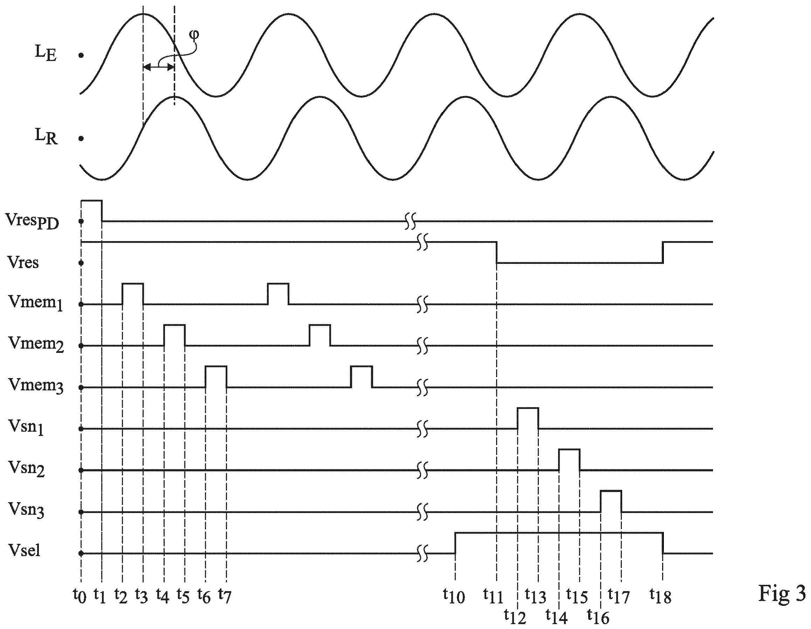

Un mode de fonctionnement du pixel TOF de la figure 2 va maintenant être décrit plus en détail en relation avec la figure 3.

La figure 3 est un chronogramme du signal lumineux LE émis par la source lumineuse 17 associée au capteur 1, du signal lumineux L_{R} reçu par le pixel TOF, et des signaux numériques Vres_{PD}, Vres, Vmemᵢ, Vsnᵢ et Vsel. Par défaut, les signaux Vres_{PD}, Vmemᵢ, Vsnᵢ, et Vsel sont à un niveau bas et le signal Vres est à un niveau haut.

On procède tout d'abord à une remise à zéro de l'élément photosensible PD en mettant le transistor Tres_{PD} à l'état passant (signal Vres_{PD} à l'état haut) entre des instants t₀ et t₁. Un cycle d'intégration du pixel commence alors et est synchronisé sur le signal L_{E}.

Pendant le cycle d'intégration, on procède aux transferts des charges photogénérées dans la zone photosensible PD vers les zones de stockage memᵢ. Pour cela, les transistors de transfert Tmemᵢ sont mis à l'état passant chacun à leur tour. Plus particulièrement, le transistor Tmem₁ est mis à l'état passant (Vmem₁ haut) entre des instants t₂ et t₃, le transistor Tmem₂ est mis à l'état passant (Vmem₂ haut) entre des instants t₄ et t₅, et le transistor Tmem₃ est mis à l'état passant (Vmem₃ haut) entre des instants t₆ et t₇. Comme indiqué précédemment, l'ensemble de ces trois transferts est ensuite répété un grand nombre de fois. Pendant toute la durée du cycle d'intégration, le signal Vres est à l'état haut, le transistor Tres est passant, et la tension du noeud de lecture SN est sensiblement égale au potentiel haut de référence.

A la fin du cycle d'intégration, à partir d'un instant t10, on procède à la lecture des charges accumulées dans chacune des zones de stockage memᵢ. Pour cela, les transistors de lecture Tsnᵢ sont mis à l'état passant chacun à leur tour, et le niveau de tension sur le noeud SN est mesuré et mémorisé après chaque lecture des charges accumulées dans une zone de stockage memᵢ. Plus particulièrement, le transistor Tsel est mis à l'état passant (Vsel haut) à l'instant t₁₀ et le transistor de précharge Tres est mis à l'état bloqué (Vres bas) à un instant t₁₁. Le transistor Tsn1 est ensuite mis à l'état passant (Vsn1 haut) entre des instants successifs t₁₂ et t₁₃, puis la séquence sur Tres et Tsn est répétée par l'application d'une nouvelle impulsion de précharge sur le transistor Tres avant la lecture du second échantillon, suivi par le passage à l'état passant du transistor Tsn₂ (Vsn₂ haut) entre des instants successifs t₁₄ et t₁₅, et, finalement, cette séquence est répétée une troisième fois avec l'application d'une impulsion sur Tres et la lecture du troisième échantillon lorsque le transistor Tsn₃ est mis à l'état passant (Vsn₃ haut) entre des instants successifs t₁₆ et t₁₇. Des premier, deuxième et troisième niveaux de tension du noeud SN sont mesurés et mémorisés, respectivement entre les instants t₁₃ et t₁₄, entre les instants t₁₅ et t₁₆, et entre l'instant t₁₇ et un instant t₁₈. A l'instant t₁₈, le signal Vsel est remis à l'état bas et le signal Vres est remis à l'état haut. Un nouveau cycle d'intégration peut alors commencer.

Dans ce mode de fonctionnement, les premier, deuxième et troisième niveaux de tension mesurés sont représentatifs des charges accumulées, respectivement, dans la zone de stockage mem₁, dans la zone de stockage mem₂, et dans la zone de stockage mem₃. Dans une variante de réalisation préférée, on prévoit une remise à zéro du noeud de lecture SN après chaque lecture des charges accumulées dans une zone de stockage memᵢ. Dans ce cas, les premier, deuxième et troisième niveaux de tension sont représentatifs des charges accumulées dans une seule zone de stockage, respectivement mem₁, mem₂, et mem₃.

Ces trois niveaux de tension permettent de déterminer le déphasage ϕ entre les signaux lumineux LE et L_{R}, et donc d'en déduire la distance séparant le pixel du point de la scène auquel le pixel est conjugué.

Bien que l'on ait décrit un mode de réalisation et de commande d'un circuit de pixel TOF dans le cas d'un pixel comprenant trois ensembles identiques Sᵢ, le déphasage ϕ entre les signaux LE et L_{R} peut également être déterminé en utilisant un pixel TOF comprenant plus de trois ensembles Sᵢ, par exemple quatre ensembles Sᵢ.

A titre d'exemple, la durée d'un transfert vers une zone de stockage memᵢ, est comprise entre 5 et 30 ns. La durée séparant deux transferts vers une même zone de stockage memᵢ est par exemple de 40 ns quand la fréquence de ces signaux est de 25 MHz. Dans ce cas, la durée d'un cycle d'intégration peut être de 10 ms environ lorsque les transferts de charges vers chacune des zones de stockage memᵢ sont réalisés 250000 fois chacun. La durée d'un transfert de charges depuis une zone de stockage memᵢ vers le noeud de lecture SN est par exemple comprise entre 1 et 10 µs.

Dans un pixel, en quelques nanosecondes, peu de charges sont photogénérées dans l'élément photosensible PD, par exemple entre 0 et 10 charges. Ces charges doivent être intégralement transférées vers une zone de stockage memᵢ. En particulier, aucune charge ne doit rester bloquée dans l'élément photosensible PD ou dans le canal du transistor Tmemᵢ correspondant.

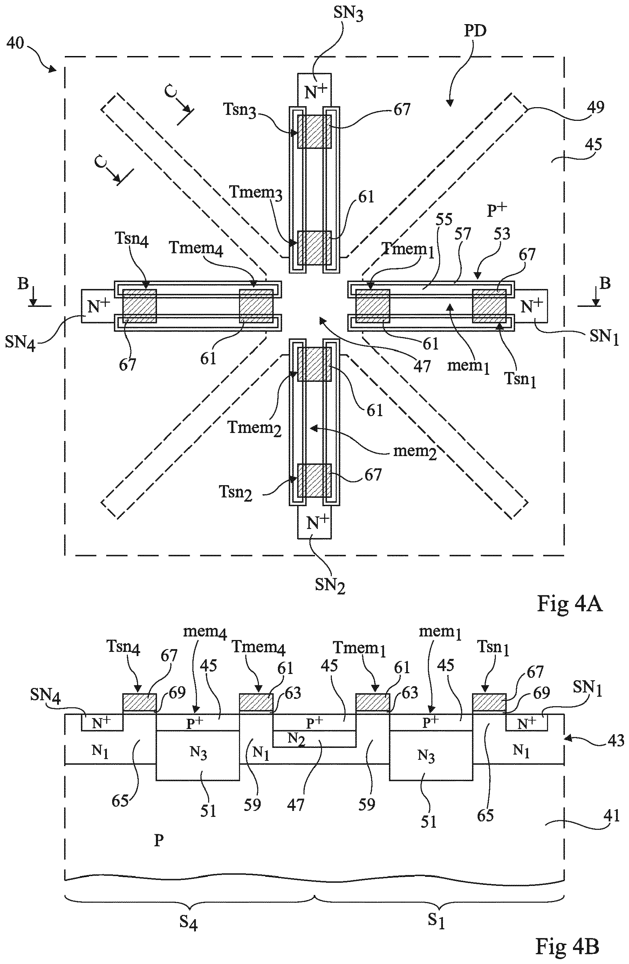

Un mode de réalisation d'un pixel TOF permettant un transfert complet des charges photogénérées dans la zone photosensible PD vers des zones de stockage memᵢ va maintenant être décrit en relation avec les figures 4A à 4C.

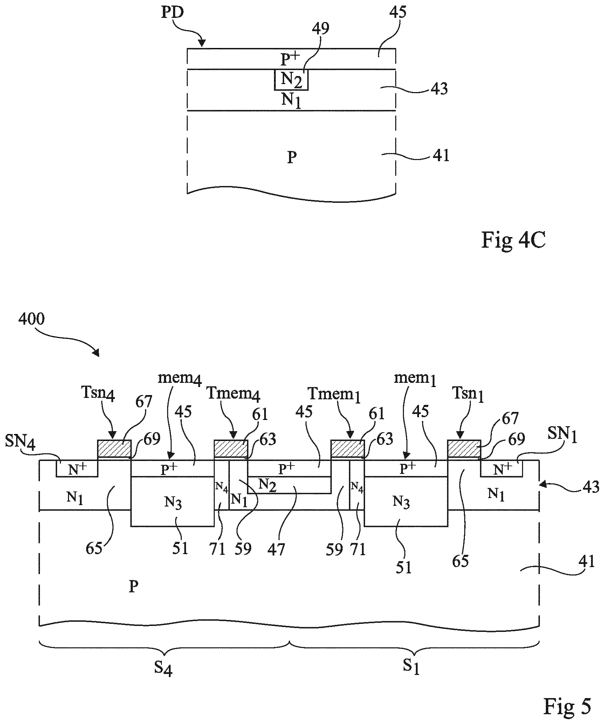

Les figures 4A à 4C représentent schématiquement un mode de réalisation d'un pixel TOF, la figure 4A étant une vue de dessus de ce pixel et les figures 4B et 4C étant des vues en coupe respectivement selon les plans BB et CC de la figure 4A. Dans ce mode de réalisation, un pixel TOF 40 comprend quatre ensembles Sᵢ, avec i égal à 1, 2, 3 ou 4. Chaque ensemble Sᵢ comprend un transistor de transfert Tmemᵢ, une zone de stockage memᵢ, et un transistor de lecture Tsnᵢ.

Le pixel TOF 40 comprend une zone photosensible PD comportant, sur un substrat semiconducteur 41 dopé de type P, une couche 43 dopée de type N, de niveau de dopage N₁. La couche 43 est revêtue d'une couche 45 fortement dopée de type P (P⁺).

Le pixel TOF 40 comprend également, dans la couche 43, une zone de collection de charges 47 dopée de type N, de niveau de dopage N₂ supérieur à N₁, la zone de collection 47 étant revêtue de la couche 45. La zone de collection de charges 47 se prolonge par des doigts 49 revêtus de la couche 45 et s'étendant dans la couche 43. Les doigts 49 sont dopés de type N, de même niveau de dopage N₂ que la zone de collection 47.

Chacune des zones de stockage memᵢ du pixel comprend un caisson 51 dopé de type N, de niveau de dopage N₃ supérieur à N₂. Chaque caisson 51 est revêtu de la couche P⁺ 45, s'étend à travers tout ou partie de l'épaisseur de la couche 43, et peut pénétrer dans le substrat 41. Chaque zone de stockage memᵢ est délimitée latéralement par deux électrodes verticales isolées 53 qui s'étendent à partir de la surface supérieure du pixel et pénètrent dans le substrat 41 jusqu'à une profondeur au moins égale à celle du caisson 51. Les électrodes 53 comprennent un matériau conducteur 55, par exemple du silicium polycristallin dopé, bordé d'une couche d'un matériau isolant 57, par exemple de l'oxyde de silicium. Chaque zone de stockage memᵢ s'étend entre la zone de collection de charges 47 et une zone de lecture SNᵢ fortement dopée de type N (N⁺). Les zones de lecture SNᵢ sont de préférence électriquement connectées les unes aux autres et correspondent au noeud de lecture SN décrit en relation avec la figure 2. Chaque zone de stockage memᵢ est séparée de la zone de collection 47 par une portion 59 de la couche 43 au niveau de laquelle la couche 43 n'est pas revêtue de la couche P⁺ 45 mais de la grille 61 du transistor de transfert Tmemᵢ correspondant, la grille 61 étant isolée de la couche 43 par une couche d'isolant de grille 63. Chaque zone de stockage memᵢ est séparée de la zone de lecture SNᵢ correspondante par une portion 65 de la couche 43 au niveau de laquelle la couche 43 n'est pas revêtue de la couche P⁺ 45 mais de la grille 67 du transistor de lecture Tsnᵢ, la grille 67 étant isolée de la couche 43 par une couche d'isolant de grille 69.

Dans ce mode de réalisation, quatre zones de stockage memᵢ et quatre doigts 49 sont régulièrement disposés autour de la zone de collection de charges 47, cette dernière étant disposée dans une partie sensiblement centrale de la zone photosensible PD. Comme cela se voit en figure 4A, les zones de stockage memᵢ peuvent être allongées, par exemple de forme rectangulaire, chaque zone memᵢ s'étendant alors en largeur entre deux électrodes verticales isolées 53 parallèles et en vis-à-vis l'une de l'autre. Bien que cela ne soit pas représenté ici, chacun des ensembles Sᵢ est revêtu d'un écran opaque à la lumière de sorte qu'aucune charge ne puisse être photogénérée dans les zones de stockage memᵢ. En outre, la zone photosensible PD est délimitée par des structures d'isolement non représentées, par exemple par des électrodes verticales isolées similaires aux électrodes 53.

En fonctionnement, le substrat 41 est connecté à un potentiel bas de référence, par exemple la masse. Les électrodes isolées 53 sont connectées à un potentiel inférieur ou égal à 0 V, par exemple -2 V, d'où il résulte que des trous s'accumulent le long de leurs parois. Une telle accumulation de trous permet de réduire les courants d'obscurité, et, en outre, de connecter électriquement le substrat 41 à la couche P⁺ 45 qui est alors au potentiel bas de référence. La zone photosensible PD et les zones de stockage memᵢ correspondent donc à des diodes dites "pincées". En outre, les niveaux de dopages N₁, N₂ et N₃ sont choisis de manière que, en l'absence d'éclairement, les diodes correspondant à la zone photosensible PD et aux zones de stockage memᵢ soient complètement déplétées, et que le maximum du puits de potentiel électrostatique dans les caissons 51 soit plus élevé que celui dans la zone de collection 47 et les doigts 49, lui-même étant plus élevé que celui dans la couche 43 de la zone photosensible PD.

Lorsque le pixel reçoit de la lumière en provenance d'une scène, des paires électron-trou sont photogénérées dans la zone photosensible PD. Les trous sont évacués vers le substrat 41 et les électrons sont attirés dans la couche 43 de la zone photosensible PD. Du fait que le potentiel électrostatique est plus élevé dans la zone de collection 47 et dans les doigts 49 que dans la couche 43, les électrons sont attirés dans les doigts 49, et sont drainés vers la zone de collection de charges 47.

Le transfert d'électrons de la zone de collection de charges 47 vers une zone de stockage memᵢ se fait en volume plutôt qu'en surface. En d'autres termes, les électrons transférés vont du caisson N₂ 47 au caisson N₃ 51 sans atteindre l'interface entre la couche d'isolant de grille 63 et la couche 43, ce qui permet avantageusement d'empêcher que des électrons ne se recombinent avec des défauts de cette interface. Ainsi, les électrons accumulés dans la zone de collection 47 sont bien tous transférés vers la zone de stockage memᵢ.

De manière avantageuse, la surface du pixel 40 peut être petite, par exemple de l'ordre de 3 µm*3 µm. Cela résulte notamment du fait que les zones de stockage memᵢ peuvent avoir des petites dimensions, par exemple environ 0,2 µm de largeur et environ 1 µm de longueur.

Bien que l'on ait décrit des doigts 49 de même niveau de dopage que la zone de collection de charge, dans des variantes de réalisation le niveau de dopage des doigts 49 peut être compris entre les niveaux de dopage N₁ et N₂. Pour chaque doigt 49, ce niveau de dopage peut être constant ou augmenter quand on se rapproche de la zone de collection de charges 47. Dans ce dernier cas, les électrons seront drainés plus efficacement vers la zone de collection de charges.

A titre d'exemple, le substrat 41 est en silicium. La couche 43 peut être formée par épitaxie sur le substrat 41 et être dopée in situ de type N à un niveau de dopage N₁. L'épaisseur de la couche 43 est par exemple de l'ordre de 500 nm. Le niveau de dopage N₁ est par exemple compris entre 5.10¹⁵ et 10¹⁷ at/cm³, par exemple 5.10¹⁶ at/cm³. La zone de collection de charges 47 et les doigts 49 peuvent être formés par implantation d'atomes dopants dans la couche 43. L'épaisseur de la zone 47 et des doigts 49 peut être de l'ordre de 300 nm. La zone de collection peut avoir une surface de l'ordre de 500 nm*500 nm et les doigts 49 peuvent avoir une largeur de l'ordre de 200 nm. Le niveau de dopage N₂ est par exemple compris entre 5.10¹⁶ et 5.10¹⁷ at/cm³, par exemple 2.10¹⁷ at/cm³. Le caisson 51 peut être formé par implantation d'atomes dopants dans la couche 43, les atomes dopants pénétrant éventuellement jusque dans le substrat 41. L'épaisseur du caisson 51 est par exemple de l'ordre de 0,5 µm. Le niveau de dopage N₃ est par exemple compris entre 1 et 8.10¹⁷ at/cm³, par exemple 4.10¹⁷ at/cm³. La longueur des grilles 61 et/ou 67, peut être de 300 nm environ. La couche P⁺ 45 est par exemple formée par implantation d'atomes dopants et peut avoir une épaisseur de 100 nm environ. Le niveau de dopage de la couche 45 peut être compris entre 2.10¹⁷ et 10¹⁹ at/cm³, par exemple 5.10¹⁸ at/cm³. Les zones de lecture SNᵢ peuvent être formées par implantation d'atomes dopants dans la couche 43. Le niveau de dopage N⁺ des zones de lecture SNᵢ 45 peut être compris entre 2.10²⁰ et 10²¹ at/cm³, par exemple 6.10²¹ at/cm³. Le signal Tmemᵢ est par exemple compris entre -2 et 0 V à l'état bas, et entre 0 et 3,6 V à l'état haut. Le signal Vsnᵢ est par exemple compris entre -2 et 0 V à l'état bas, et entre 1 et 3,6 V à l'état haut.

La figure 5, qui correspond à la figure 4B, représente schématiquement une variante de réalisation du pixel TOF 40 des figures 4A à 4C.

Dans cette variante, un pixel TOF 400 comprend les mêmes éléments que ceux du pixel TOF 40 des figures 4A à 4C, désignés par les mêmes références. Le pixel 400 comprend en outre, sous chaque grille 61, une région intermédiaire 71 dopée de type N, intercalée entre la portion 59 et la zone de stockage memᵢ. Cette région intermédiaire 71 a un niveau de dopage N₄ supérieur à N₁ et inférieur à N₃. Il en résulte que le potentiel électrostatique dans la région intermédiaire 71 est plus élevé que celui dans la portion 59 et moins élevé que celui dans le caisson 51. Cela permet avantageusement d'éviter que, lors d'un transfert d'électrons de la zone 47 vers une zone memᵢ, des électrons restent piégés sous la grille du transistor Tmemᵢ et puissent revenir dans la zone de collection 47.

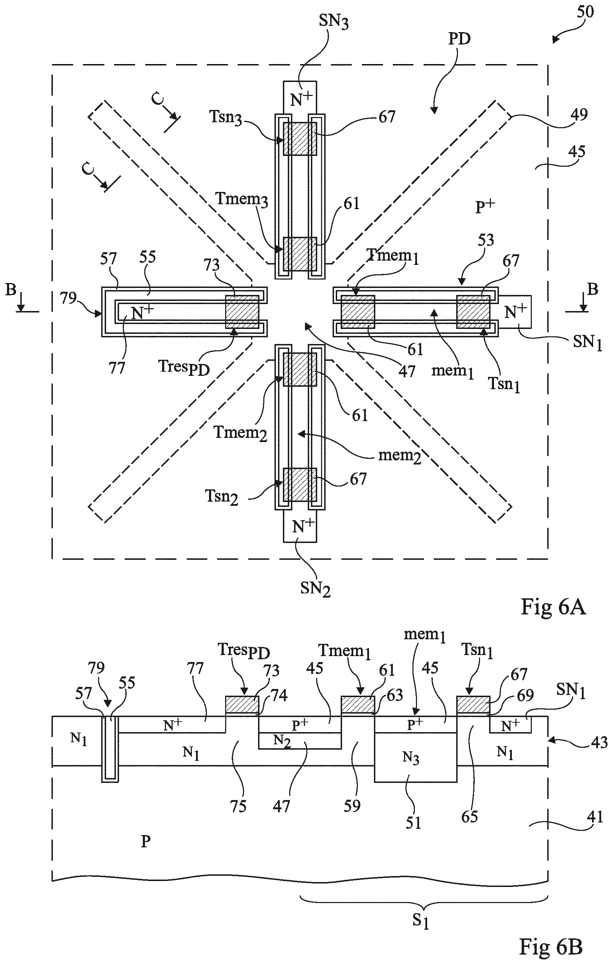

Les figures 6A et 6B représentent schématiquement une autre variante de réalisation d'un pixel TOF du type de celui de la figure 2, la figure 6A étant une vue de dessus du pixel et la figure 6B étant une vue en coupe selon le plan BB de la figure 6A. Dans cette variante de réalisation, un pixel TOF 50 comprend trois ensembles Sᵢ, avec i égal à 1, 2 ou 3, et, en outre, un transistor Tres_{PD}.

Le pixel TOF 50 est similaire au pixel TOF 40 des figures 4A à 4C à la différence que l'ensemble S₄ du pixel TOF 40 est remplacé par un transistor Tres_{PD} de remise à zéro de la zone photosensible PD. Le transistor Tres_{PD} comprend une grille 73 séparée de la couche 43 par une couche d'isolant de grille 74. La grille 73 est disposée sur une portion 75 de la couche 43 s'étendant entre la zone de collection de charges 47 et une région 77 fortement dopée de type N (N⁺) constituant le drain du transistor Tres_{PD} et étant destinée à être connectée à un potentiel haut. Dans cet exemple, la région N⁺ 77 est délimitée latéralement, sauf du côté de la zone de collection de charges, par une électrode verticale isolée 79 similaire aux électrodes isolées 53. On pourra prévoir de remplacer l'électrode 79 par une autre structure d'isolement. Comme chacun des ensembles Sᵢ, le transistor Tres_{PD} peut être revêtu d'un écran opaque à la lumière. A titre d'exemple, le signal Vres_{PD} appliqué sur la grille 73 du transistor Tres_{PD} est compris entre 2 et 3,5 V à l'état haut.

Bien que l'on ait décrit un exemple de réalisation d'un transistor Tres_{PD}, ce transistor peut avoir d'autres formes. En outre, le transistor Tres_{PD} peut être utilisé comme dispositif anti-éblouissement en adaptant les potentiels appliqués à la zone N⁺ 77 et à la grille du transistor Tres_{PD}.

Dans les pixels décrits précédemment, les zones de stockage s'étendent entre la zone de collection de charges de la zone photosensible et des zones de lecture correspondantes. Dans de tels pixels, les charges photogénérées dans la zone photosensible sont régulièrement transférées de la zone de collection de charges vers les zones de stockage pour y être accumulées. Dans un autre mode de réalisation, on prévoit un pixel comprenant, en plus des zones de stockage, des zones mémoire similaires aux zones de stockage. Chaque zone mémoire est intercalée entre une zone de stockage et une zone de lecture, une même zone de stockage pouvant être associée à plusieurs zones mémoire. Chaque zone de stockage s'étend alors entre la zone de collection de charges et la ou les zones mémoire auxquelles elle est associée. Dans un tel pixel, les charges photogénérées sont régulièrement transférées de la zone de collection 47 vers les zones de stockage, et des zones de stockage vers les zones mémoire. Ainsi, pendant que des charges sont transférées vers une zone de stockage, des charges préalablement accumulées dans une autre zone de stockage sont transférées vers une zone mémoire associée à cette autre zone de stockage. La prévision de zones mémoire intercalées entre les zones de stockage et les zones de lecture permet un stockage intermédiaire dans les zones de stockage avant transfert vers l'une des zones mémoire. Cela présente notamment les avantages suivants :
zone de passage entre la zone de collection 47 et le transistor Tmemi plus facile à dessiner afin d'éviter des rétrécissements dans cette zone pouvant dégrader le transfert des charges,
possibilité de réaliser la lecture du collecteur avec uniquement deux signaux de commande, ces deux signaux étant par exemple des sinusoïdes en opposition de phase.

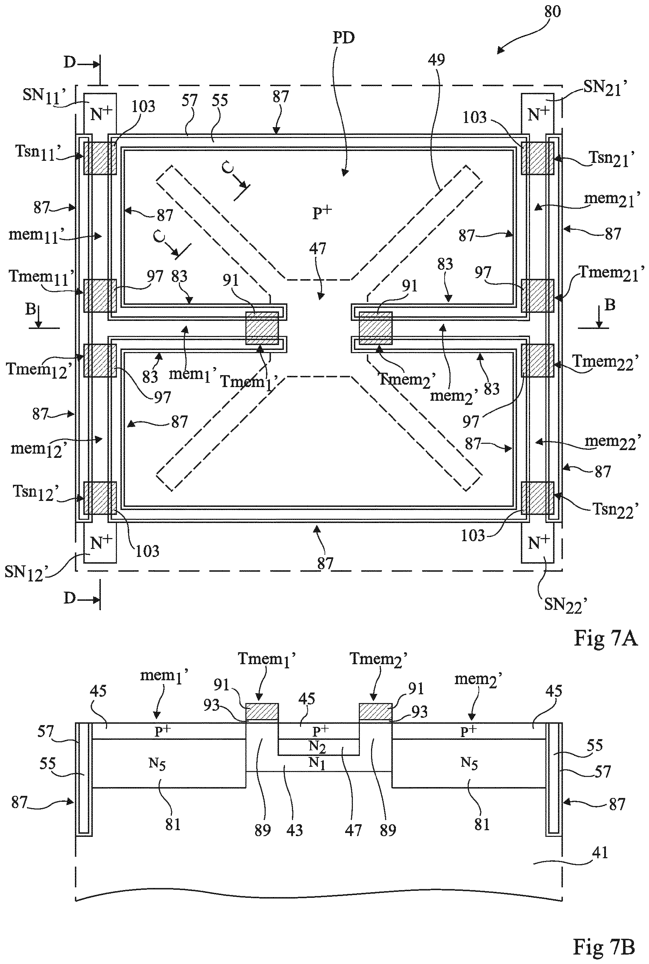

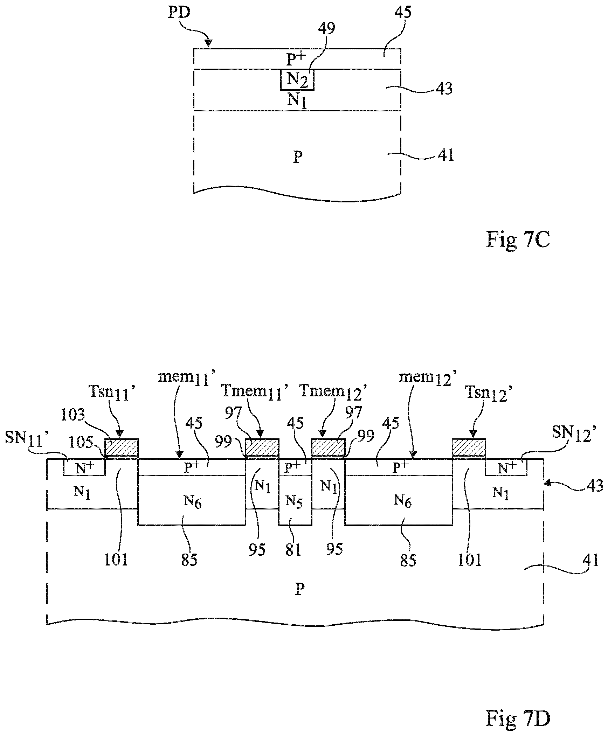

Un mode de réalisation d'un pixel TOF 80 comprenant des zones mémoire intercalées entre les zones de stockage et les zones de lecture va maintenant être décrit en relation avec les figures 7A à 7D. La figure 7A est une vue de dessus du pixel 80, les figures 7B, 7C et 7D étant des vues en coupe respectivement selon les plans BB, CC et DD de la figure 7A.

Dans ce mode de réalisation, le pixel TOF 80 comprend deux ensembles comportant chacun une zone de stockage memᵢ', avec i égal à 1 ou 2, associée à deux zones mémoire memᵢ₁' et memᵢ₂', elles-mêmes associées à deux zones de lecture SNᵢ₁' et SNᵢ₂' respectivement. Chaque ensemble comprend un premier transistor de transfert Tmemᵢ' autorisant ou bloquant un transfert de charges de la zone de collection de charges vers la zone de stockage memᵢ', deux deuxièmes transistors de transfert Tmemᵢ₁' et Tmemi₂' autorisant ou bloquant un transfert de charges de la zone de stockage memᵢ' vers les zones mémoire memi₁' et memᵢ₂' respectivement, et deux transistors de lecture Tsnᵢ₁' et Tsnᵢ₂' autorisant ou bloquant un transfert de charges des zones mémoire memi₁' et memᵢ₂' vers les zones de lecture respectives SNi₁' et SNᵢ₂'.

Plus particulièrement, le pixel TOF 80 comprend la zone photosensible PD comportant, sur le substrat semiconducteur 41, la couche 43 revêtue de la couche 45 P⁺, et comprend également la zone de collection de charges 47 et les doigts 49. Chacune des zones de stockage memᵢ' comprend un caisson 81 dopé de type N à un niveau de dopage N₅ supérieur à N₂, le caisson 81 étant revêtu de la couche P⁺ 45. Chaque caisson 81 s'étend à travers tout ou partie de l'épaisseur de la couche 43 et peut pénétrer dans le substrat 41. Chacune des zones de stockage memᵢ' est délimitée latéralement par deux électrodes verticales isolées 83 similaires aux électrodes 53 décrites précédemment. Chacune des zones mémoire memi₁' et memᵢ₂' comprend un caisson 85 dopé de type N à un niveau de dopage N₆ supérieur à N₅, le caisson 85 étant revêtu de la couche P⁺ 45. Chaque caisson 85 s'étend à travers tout ou partie de l'épaisseur de la couche 43 et peut pénétrer dans le substrat 41. Chacune des zones mémoire memi₁' et memᵢ₂' est délimitée latéralement par deux électrodes verticales isolées 87 similaires aux électrodes isolées 53. Dans cet exemple, chacune des zones de stockage memᵢ' et des zones mémoire memi₁' et memᵢ₂' est allongée, de forme rectangulaire, et s'étend en largeur entre deux électrodes isolées correspondantes, parallèles et en vis-à-vis l'une de l'autre. Comme cela se voit en figure 7A, l'une des deux électrodes 87 délimitant une zone mémoire memi₁' ou memᵢ₂' peut correspondre à un prolongement d'une électrode 83 délimitant la zone de stockage memᵢ'. En outre, comme dans cet exemple les zones mémoire memi₁' et memᵢ₂' bordent des côtés de la zone photosensible PD (à gauche et à droite en figure 7A), les électrodes 87 délimitant les zones mémoire memi₁' et memᵢ₂' du côté de la zone photosensible peuvent se prolonger au-delà des zones mémoire pour délimiter des côtés de la zone photosensible PD (en haut et en bas en figure 7A) qui ne sont pas bordés par ces zones mémoire. Les zones de stockage memᵢ' et les zones mémoire memi₁' et memᵢ₂' sont revêtues d'un écran opaque à la lumière non représenté. Chacune des zones de lecture SNi₁' et SNi₂' est fortement dopée de type N (N⁺). Les zones de lecture SNi₁' et SNi₂' sont électriquement connectées les unes aux autres et constituent un noeud de lecture du pixel 80. De la même manière que précédemment, une portion 89 de couche 43 sépare chaque zone de stockage memᵢ' de la zone de collection de charges 47. Cette portion 89 n'est pas revêtue de la couche P⁺ 45 mais de la grille 91 du transistor de transfert Tmemᵢ', isolée de la couche 43 par une couche d'isolant de grille 93. Chaque zone mémoire memi₁' et memᵢ₂' est séparée de la zone de stockage memᵢ' correspondante par une portion 95 de la couche 43. Cette portion 95 n'est pas revêtue de la couche P⁺ 45 mais de la grille 97 du transistor de transfert Tmemᵢ₁' ou Tmemᵢ₂' correspondant, isolée de la couche 43 par une couche d'isolant de grille 99. Chaque zone de lecture SNi₁' et SNi₂' est séparée de la zone mémoire memi₁' ou memᵢ₂' correspondante par une portion 101 de la couche 43. Cette portion 101 de la couche 43 n'est pas revêtue de la couche P⁺ 45 mais de la grille 103 du transistor de lecture Tsnᵢ₁' ou Tsnᵢ₂' correspondant, isolée de la couche 43 par une couche d'isolant de grille 105. La structure des transistors Tmemᵢ', Tmemᵢ₁" Tmemᵢ₂', Tsnᵢ₁', et Tsnᵢ₂' est similaire à celle des transistors Tmemᵢ décrits précédemment, d'où il résulte que les transferts de charges autorisés par ces transistors se font en volume plutôt qu'en surface.

En fonctionnement, le substrat 41 est connecté à un potentiel bas de référence et les électrodes isolées 83 et 87 sont connectées à un potentiel inférieur ou égal à 0 V. Les niveaux de dopage N₁, N₂, N₅ et N₆ sont choisis pour que, en l'absence d'éclairement, la zone photosensible PD et les zones memᵢ', memi₁' et memᵢ₂' correspondent à des diodes pincées complètement déplétées, que le maximum du puits de potentiel électrostatique dans les caissons 85 soit plus élevé que celui dans les caissons 81, et que le maximum du puits de potentiel électrostatique dans les caissons 81 soit plus élevé que celui dans la zone de collection de charge 47 et dans les doigts 49.

A titre d'exemple, les dimensions des grilles des transistors du pixel 80 et des zones de stockage et de mémoire sont sensiblement les mêmes que celles des grilles des transistors et des zones de stockage des pixels 40, 400 et 50 décrits précédemment. En outre, les caissons 81 et 91 du pixel 80 peuvent avoir des épaisseurs du même ordre que celle des caissons 51 des pixels 40, 400 et 50. Le niveau de dopage N₅ peut être compris entre 1 et 4.10¹⁷ at/cm³, par exemple 2.10¹⁷ at/cm³. Le niveau de dopage N₆ peut être compris entre 4 et 8.10¹⁷ at/cm³, par exemple 4.10¹⁷ at/cm³.

Bien que l'on ait décrit un pixel 80 comprenant deux ensembles d'une zone de stockage associée à deux zones mémoire, le pixel peut comprendre plus de deux ensembles d'une zone de stockage associée à au moins une zone mémoire.

Des modes de réalisation particuliers ont été décrits. Diverses variantes et modifications apparaîtront à l'homme de l'art. En particulier, une matrice de pixels TOF du type de ceux décrits précédemment peut être commandée selon un mode de commande à obturation globale ("global shutter" en anglais) ou selon un mode de commande à lecture à balayage ("rolling shutter" en anglais).

En outre, on peut prévoir que la matrice 3 du capteur 1 comprenne une pluralité de groupes de pixels, chaque groupe comportant un pixel TOF, et des pixels adaptés à détecter de la lumière rouge, verte, et bleue afin d'obtenir une image en relief et en couleur d'une scène.

Les modes de réalisation décrits ne se limitent pas aux exemples particuliers de disposition et de configuration des électrodes verticales représentés aux figures 4A à 4C, 5, 6A, 6B et 7A à 7D. D'autres dispositions d'électrodes verticales et/ou un nombre d'électrodes par pixel différent de ce qui a été représenté pourront être prévus. De plus, bien que l'on ait décrit des modes de réalisation de pixels dans lesquels on détecte, stocke et transfère des charges photogénérées correspondant à des électrons, l'homme de l'art saura réaliser des pixels similaires dans lesquels les charges sont des trous en inversant tous les types de conductivité et en adaptant les niveaux de tensions appliqués aux divers éléments de ces pixels.

Divers modes de réalisation avec diverses variantes ont été décrits ci-dessus. L'homme de l'art pourra combiner divers éléments de ces divers modes de réalisation et variantes sans faire preuve d'activité inventive. Par exemple, on a décrit une région intermédiaire 71 disposée sous la grille d'un transistor Tmemᵢ. Une région intermédiaire peut également être prévue sous les grilles des transistors Tsnᵢ, Tmemᵢ', Tmemᵢ₁" Tmemᵢ₂', Tsnᵢ₁' et/ou Tsnᵢ₂'. Cette région intermédiaire sera disposée de manière à border la zone ou région dopée de type N vers laquelle s'effectue le transfert de charges, et aura un niveau de dopage supérieur à celui de la couche 43 et inférieur à celui de la zone ou région vers laquelle s'effectue ce transfert.

On pourra également prévoir qu'un transistor de remise à zéro de la zone photosensible PD soit prévu dans un pixel du type de celui des figures 7A à 7C. En outre, dans un pixel dépourvu de transistor de remise à zéro de l'élément photosensible, cette remise à zéro peut être effectuée en commandant les transistors du pixel de manière à créer un chemin conducteur entre l'élément photosensible et un potentiel haut, par exemple le potentiel Vdd.

## Revendications

1. Pixel (40, 400, 50, 80) de détection de temps de vol, comprenant :
une zone photosensible (PD) comportant une première couche (43) dopée d'un premier type de conductivité (N₁) ;
une zone de collection de charges (47) s'étendant dans la première couche et étant plus fortement dopée du premier type (N₂) que la première couche ; et
au moins deux zones de stockage de charges (mem₁, mem₂, mem₃, mem₄ ; mem₁', mem₂') s'étendant à partir de la zone de collection et comprenant chacune un premier caisson (51 ; 81) plus fortement dopé du premier type (N₃ ; N₅) que la zone de collection **caractérisé en ce que**,
le premier caisson étant séparé de ladite zone de collection par une première portion (59 ; 89) de la première couche revêtue d'une première grille (61 ; 91), chaque zone de stockage de charges étant délimitée latéralement par deux électrodes conductrices isolées (53 ; 83), parallèles et en vis-à-vis l'une de l'autre.

2. Pixel selon la revendication 1, dans lequel une deuxième couche (45) dopée du deuxième type de conductivité revêt la zone photosensible (PD), la zone de collection de charges (47) et les premiers caissons.

3. Pixel selon la revendication 1 ou 2, dans lequel la première couche (43) repose sur un substrat semiconducteur (41) dopé du deuxième type de conductivité (P).

4. Pixel selon l'une quelconque des revendications 1 à 3, dans lequel la zone de collection (47) se prolonge par des doigts (49) dopés du premier type, revêtus de la deuxième couche (45), et s'étendant dans la zone photosensible (PD), les doigts étant plus fortement dopés que la première couche (43) et plus faiblement dopés ou de même niveau de dopage que la zone de collection.

5. Pixel (40, 400, 50, 80) selon l'une quelconque des revendications 1 à 4, dans lequel la zone de collection (47) est disposée dans une partie centrale de la zone photosensible (PD).

6. Pixel (50) selon l'une quelconque des revendications 1 à 5, comprenant en outre, sous chaque première grille (61), une zone intermédiaire (71) dopée du premier type intercalée entre la première portion (59) correspondante et le premier caisson (51) correspondant, la zone intermédiaire étant plus fortement dopée que la première portion correspondante et plus faiblement dopée que le premier caisson correspondant.

7. Pixel (400) selon l'une quelconque des revendications 1 à 6, comprenant en outre une région (77) plus fortement dopée du deuxième type (N⁺) que la zone de collection (47), adaptée à être couplée à un potentiel de référence, et séparée de la zone de collection par une deuxième portion (75) de la première couche (43) revêtue d'une deuxième grille (73).

8. Pixel (40, 400, 50) selon l'une quelconque des revendications 1 à 7, comprenant en outre, pour chaque zone de stockage (mem₁, mem₂, mem₃, mem₄), une zone de lecture (SN₁, SN₂, SN₃, SN₄) plus fortement dopée du deuxième type (N⁺) que le premier caisson (51), la zone de stockage s'étendant jusqu'à la zone de lecture et étant séparée de la zone de lecture par une troisième portion (65) de la première couche (43) revêtue d'une troisième grille (67).

9. Pixel (80) selon l'une quelconque des revendications 1 à 7, comprenant en outre, pour chaque zone de stockage (mem₁', mem₂'), au moins une zone mémoire (mem₁₁', mem₁₂', mem₂₁', mem₂₂') s'étendant à partir de la zone de stockage et comprenant un deuxième caisson (85) plus fortement dopé du deuxième type (N₆) que le premier caisson (81), revêtu de la deuxième couche (45), et séparé du premier caisson par une troisième portion (95) de la première couche (43) revêtue d'une troisième grille (97), la zone mémoire étant délimitée latéralement par deux électrodes conductrices isolées (87), parallèles et en vis-à-vis l'une de l'autre.

10. Pixel (80) selon la revendication 9, comprenant deux zones de stockage (mem₁', mem₂') dont chacune est associée à deux zones mémoire (mem₁₁', mem₁₂', mem₂₁', mem₂₂').

11. Pixel (80) selon la revendication 9 ou 10, comprenant en outre, pour chaque zone mémoire (mem₁₁', mem₁₂', mem₂₁', mem₂₂'), une zone de lecture (SN₁₁', SN₁₂', SN₂₁', SN₂₂') plus fortement dopée du deuxième type (N⁺) que le deuxième caisson (85), la zone mémoire s'étendant jusqu'à la zone de lecture et étant séparée de la zone de lecture par une quatrième portion (101) de la première couche (43) revêtue d'une quatrième grille (103).

12. Pixel selon l'une quelconque des revendications 1 à 11, dans lequel chaque zone de lecture (SN₁, SN₂, SN₃, SN₄ ; SN₁₁', SN₁₂', SN₂₁', SN₂₂') est électriquement connectée à une même borne d'un circuit de lecture.

13. Capteur d'image (1) comprenant une matrice (3) de pixels (40, 400, 50, 80) selon l'une quelconque des revendications 1 à 12 associée à une source d'émission (17) de lumière modulée (L_{E}), et des moyens (15) adaptés à synchroniser ladite source et des potentiels de commande appliqués aux grilles de transistors du pixel.

14. Procédé de commande du pixel (40, 400, 50, 80) selon l'une quelconque des revendications 1 à 12, dans lequel chaque première grille (61, 91) est adaptée à recevoir ou non un premier potentiel pour autoriser ou interdire un transfert de charges de la zone de collection (47) vers la zone de stockage (mem₁, mem₂, mem₃, mem₄ ; mem₁', mem₂') correspondante.

15. Procédé de commande selon la revendication 14 du pixel (40, 400, 50) selon la revendication 8, dans lequel chaque troisième grille (73) est adaptée à recevoir ou non un deuxième potentiel pour autoriser ou interdire un transfert de charges de la zone de stockage (mem₁, mem₂, mem₃, mem₄) correspondante vers la zone de lecture (SN₁, SN₂, SN₃, SN₄) correspondante.

16. Procédé de commande selon la revendication 14 du pixel (80) selon la revendication 11, dans lequel chaque troisième grille (97) est adaptée à recevoir ou non un deuxième potentiel pour autoriser ou interdire un transfert de charges de la zone de stockage (mem₁', mem₂') correspondante vers la zone mémoire (mem₁₁', mem₁₂', mem₂₁', mem₂₂') correspondante, et, en outre, chaque quatrième grille (103) est adaptée à recevoir ou non un troisième potentiel pour autoriser ou interdire un transfert de charges de la zone mémoire (mem₁₁', mem₁₂', mem₂₁', mem₂₂') correspondante vers la zone de lecture (SN₁₁', SN₁₂', SN₂₁', SN₂₂') correspondante.

## Patentansprüche

1. Ein Laufzeit- bzw. TOF-Detektionspixel (TOF = Time-of-Flight) (40, 400, 50, 80), das Folgendes aufweist:
einen photosensitiven Bereich (PD), der eine erste dotierte Schicht (43) eines ersten Leitfähigkeitstyps (N₁) aufweist;
einen Ladungssammelbereich (47), der sich in der ersten Schicht erstreckt und stärker mit dem ersten Typ (N₂) dotiert ist als die erste Schicht; und
zumindest zwei Ladungsspeicherungsbereiche (mem₁, mem₂, mem₃, mem₄; mem₁', mem₂'), die sich von dem Sammelbereich aus erstrecken und von denen jeder einen ersten Topf bzw. Well (51; 81) aufweist, der stärker mit dem ersten Typ (N₃; N₅) dotiert ist als der Sammelbereich, **dadurch gekennzeichnet, dass** der erste Well von dem Sammelbereich durch einen ersten Teil (59; 89) der ersten Schicht getrennt ist, der mit einem erster Gatter bzw. Gate (61; 91) beschichtet ist, wobei jeder Ladungssammelbereich durch zwei parallel isolierte, leitende Elektroden (53; 83) seitlich begrenzt ist, die zueinander weisen.

2. Pixel gemäß Anspruch 1, wobei eine zweite dotierte Schicht (45) des zweiten Leitfähigkeitstyps den photosensitiven Bereich (PD), den Ladungssammelbereich (47) und die ersten Wells beschichtet.

3. Pixel gemäß Anspruch 1 oder 2, wobei die erste Schicht (43) durch ein dotiertes Halbleitersubstrat (41) des zweiten Leitfähigkeitstyps (P) getragen wird.

4. Pixel gemäß einem der Ansprüche 1 oder 3, wobei sich der Sammelbereich (47) in dotierte Finger (49) des ersten Typs ausdehnt, die mit der zweiten Schicht (45) beschichtet sind, und sich in den photosensitiven Bereich (PD) ausdehnt, wobei die Finger stärker als die erste Schicht (43) dotiert sind und schwächer als der Sammelbereich dotiert oder von dem gleichen Dotierungsgrad wie der Sammelbereich sind.

5. Pixel (40, 500, 50, 80) gemäß einem der Ansprüche 1 bis 4, wobei der Sammelbereich (47) in einem mittleren Teil des photosensitiven Bereichs (PD) angeordnet ist.

6. Pixel (50) gemäß einem der Ansprüche 1 bis 5, das ferner unter jedem ersten Gate (61) einen dotierten Zwischenbereich (71) des ersten Typs aufweist, der zwischen den ersten zugehörigen Teil (59) und den ersten zugehörigen Well (51) eingeschoben ist, wobei der Zwischenbereich stärker dotiert als der erste zugehörige Teil und schwächer dotiert als der erste zugehörige Well ist.

7. Pixel (400) gemäß einem der Ansprüche 1 bis 6, das ferner einen Bereich (77) aufweist, der stärker mit dem zweiten Typ (N⁺) dotiert ist als der Sammelbereich (47), der mit einem Referenzpotential gekoppelt werden kann, und von dem Sammelbereich durch einen zweiten Teil (75) der ersten Schicht (43) getrennt ist, der mit einem zweiten Gate (73) beschichtet ist.

8. Pixel (40, 400, 50) gemäß einem der Ansprüche 1 bis 7, das ferner für jeden Speicherbereich (mem₁, mem₂, mem₃, mem₄) einen Abfühlbereich (SN₁, SN₂, SN₃, SN₄) aufweist, der stärker mit dem zweiten Typ (N⁺) als der erste Well (51) dotiert ist, wobei sich der Speicherungsbereich die gesamte Entfernung zu dem Abfühlbereich erstreckt und von dem Abfühlbereich durch einen dritten Teil (65) der erste Schicht (43) getrennt ist, der mit einem dritten Gate (67) beschichtet ist.

9. Pixel (80) gemäß einem der Ansprüche 1 bis 7, das ferner für jeden Speicherungsbereich (mem₁', mem₂') zumindest einen Speicherbereich (mem₁₁', mem₁₂', mem₂₁', mem₂₂') aufweist, der sich von dem Speicherungsbereich aus erstreckt und einen zweiten Well (85) aufweist, der stärker mit dem zweiten Typ (N₆) als der erste Well (81) dotiert ist, der mit der zweiten Schicht (45) beschichtet ist und von dem ersten Well durch einen dritten Teil (95) der ersten Schicht (43) getrennt ist, die mit einem dritten Gate (97) beschichtet ist, wobei der Speicherbereich seitlich durch zwei parallel isolierte, leitende Elektroden (87) begrenzt wird, die zueinander weisen.

10. Pixel (80) gemäß Anspruch 9, das zwei Speicherungsbereiche (mem₁', mem₂') aufweist, die jeweils mit zwei Speicherbereichen (mem₁₁', mem₁₂', mem₂₁', mem₂₂') assoziiert sind.

11. Pixel (80) gemäß Anspruch 9 oder 10, das ferner für jeden Speicherbereich (mem₁₁', mem₁₂', mem₂₁', mem₂₂') einen Abfühlbereich (SN₁₁', SN₁₂', SN₂₁', SN₂₂') aufweist, der stärker mit dem zweiten Typ (N⁺) als der zweite Well (85) dotiert ist, wobei sich der Speicherbereich die gesamte Entfernung zu dem Abfühlbereich erstreckt und von dem Abfühlbereich durch einen vierten Teil (101) der ersten Schicht (43) getrennt ist, die mit einem vierten Gate (103) beschichtet ist.

12. Pixel gemäß einem der Ansprüche 1 bis 11, wobei jeder Abfühlbereich (SN₁, SN₂, SN₃, SN₄; SN₁₁', SN₁₂', SN₂₁', SN₂₂') elektrisch mit einem gleichen Anschluss einer Leseschaltung verbunden ist.

13. Bildsensor (1), der eine Anordnung bzw. Gruppe (3) von Pixeln (40, 400, 50, 80) gemäß einem der Ansprüche 1 bis 12 aufweist, die mit einer Quelle bzw. Source (17) zur Emission modulierten Lichts (L_{E}) assoziiert sind, sowie Mittel (15), die imstande sind die Source und Steuerpotentiale zu synchronisieren, die an die Gates der Transistoren des Pixels angelegt werden.

14. Verfahren zur Steuerung der Pixel (40, 400, 50, 80) gemäß einem der Ansprüche 1 bis 12, wobei jedes erste Gate (61, 91) imstande ist ein erstes Potential zu empfangen oder nicht, um eine Ladungsübertragung von dem Sammelbereich (47) zu dem zugehörigen Speicherungsbereich (mem₁, mem₂, mem₃, mem₄; mem₁', mem₂') zu ermöglichen oder zu unterbinden.

15. Verfahren gemäß Anspruch 14 zur Steuerung des Pixels (40, 400, 50) gemäß Anspruch 8, wobei jedes Gate (73) imstande ist, ein zweites Potential aufzunehmen oder nicht, um eine Ladungsübertragung von dem entsprechenden Speicherungsbereich (mem₁, mem₂, mem₃, mem₄) zu dem zugehörigen Abfühlbereich (SN₁, SN₂, SN₃, SN₄) zu ermöglichen oder zu unterbinden.

16. Verfahren gemäß Anspruch 14 zur Steuerung des Pixels (80) gemäß Anspruch 11, wobei jedes dritte Gate (97) imstande ist oder nicht, ein zweites Potential aufzunehmen, um eine Ladungsübertragung von dem zugehörigen Speicherungsbereich (mem₁', mem₂') zu dem zugehörigen Speicherbereich (mem₁₁', mem₁₂', mem₂₁', mem₂₂') zu ermöglichen oder zu unterbinden, und ferner jedes vierte Gate (103) imstande ist, ein drittes Potential aufzunehmen oder nicht, um eine Ladungsübertragung von dem zugehörigen Speicherbereich (mem₁₁', mem₁₂', mem₂₁', mem₂₂') zu dem zugehörigen Abfühlbereich (SN₁₁', SN₁₂', SN₂₁', SN₂₂') zu ermöglichen oder zu unterbinden.

## Claims

1. A time-of-flight detection pixel (40, 400, 50, 80) comprising:
a photosensitive area (PD) comprising a first doped layer (43) of a first conductivity type (N₁);
a charge collection area (47) extending in the first layer and being more heavily doped of the first type (N₂) than the first layer; and
at least two charge storage areas (mem₁, mem₂, mem₃, mem₄; mem₁', mem₂') extending from the collection area and each comprising a first well (51; 81) more heavily doped of the first type (N₃; N₅) than the collection area, **characterized in that** the first well is separated from said collection area by a first portion (59; 89) of the first layer coated with a first gate (61; 91), each charge storage area being laterally delimited by two parallel insulated conductive electrodes (53; 83) facing each other.

2. The pixel of claim 1, wherein a second doped layer (45) of the second conductivity type coats the photosensitive area (PD), the charge collection area (47) and the first wells.

3. The pixel of claim 1 or 2, wherein the first layer (43) is supported by a doped semiconductor substrate (41) of the second conductivity type (P).

4. The pixel of any of claims 1 or 3, wherein the collection area (47) extends in doped fingers (49) of the first type, coated with the second layer (45), and extending in the photosensitive area (PD), the fingers being more heavily doped than the first layer (43) and more lightly doped than or of same doping level as the collection area.

5. The pixel (40, 400, 50, 80) of any of claims 1 to 4, wherein the collection area (47) is arranged in a central portion of the photosensitive area (PD).

6. The pixel (50) of any of claims 1 to 5, further comprising, under each first gate (61), a doped intermediate area (71) of the first type interposed between the first corresponding portion (59) and the first corresponding well (51), the intermediate area being more heavily doped than the first corresponding portion and more lightly doped than the first corresponding well.

7. The pixel (400) of any of claims 1 to 6, further comprising a region (77) more heavily doped of the second type (N⁺) than the collection area (47), capable of being coupled to a reference potential, and separated from the collection area by a second portion (75) of the first layer (43) coated with a second gate (73).

8. The pixel (40, 400, 50) of any of claims 1 to 7, further comprising, for each storage area (mem₁, mem₂, mem₃, mem₄), a sense area (SN₁, SN₂, SN₃, SN₄) more heavily doped of the second type (N⁺) than the first well (51), the storage area extending all the way to the sense area and being separated from the sense area by a third portion (65) of the first layer (43) coated with a third gate (67).

9. The pixel (80) of any of claims 1 to 7, further comprising, for each storage area (mem₁', mem₂'), at least one memory area (mem₁₁', mem₁₂', mem₂₁', mem₂₂') extending from the storage area and comprising a second well (85) more heavily doped of the second type (N₆) than the first well (81), coated with the second layer (45), and separated from the first well by a third portion (95) of the first layer (43) coated with a third gate (97), the memory area being laterally delimited by two parallel insulated conductive electrodes (87), facing each other.

10. The pixel (80) of claim 9 comprising two storage areas (mem₁', mem₂') each of which is associated with two memory areas (mem₁₁', mem₁₂', mem₂₁', mem₂₂').

11. The pixel (80) of claim 9 or 10, further comprising, for each memory area (mem₁₁', mem₁₂', mem₂₁', mem₂₂'), a sense area (SN₁₁', SN₁₂'. SN₂₁', SN₂₂') more heavily doped of the second type (N⁺) than the second well (85), the memory area extending all the way to the sense area and being separated from the sense area by a fourth portion (101) of the first layer (43) coated with a fourth gate (103).

12. The pixel of any of claims 1 to 11, wherein each sense area (SN₁, SN₂, SN₃, SN₄; SN₁₁', SN₁₂', SN₂₁', SN₂₂') is electrically connected to a same terminal of a read circuit.

13. An image sensor (1) comprising an array (3) of pixels (40, 400, 50, 80) of any of claims 1 to 12 associated with a source (17) of emission of modulated light (L_{E}), and means (15) capable of synchronizing said source and control potentials applied to the gates of transistors of the pixel.

14. A method of controlling the pixel (40, 400, 50, 80) of any of claims 1 to 12, wherein each first gate (61, 91) is capable of receiving or not a first potential to allow or forbid a charge transfer from the collection area (47) to the corresponding storage area (mem₁, mem₂, mem₃, mem₄ ; mem₁', mem₂').

15. The method of claim 14 of controlling the pixel (40, 400, 50) of claim 8, wherein each third gate (73) is capable of receiving or not a second potential to allow or forbid a charge transfer from the corresponding storage area (mem₁, mem₂, mem₃, mem₄) to the corresponding sense area (SN₁, SN₂, SN₃, SN₄).

16. The method of claim 14 of controlling the pixel (80) of claim 11, wherein each third gate (97) is capable of receiving or not a second potential to allow or forbid a charge transfer from the corresponding storage area (mem₁', mem₂') to the corresponding memory area (mem₁₁', mem₁₂', mem₂₁', mem₂₂'), and, further, each fourth gate (103) is capable of receiving or not a third potential to allow or forbid a charge transfer from the corresponding memory area (mem₁₁', mem₁₂', mem₂₁', mem₂₂') to the corresponding sense area (SN₁₁', SN₁₂', SN₂₁', SN₂₂').
